# DEMANDE DE BREVET EUROPEEN

(11) **EP 2 306 520 A1**
(43) Date de publication de la demande: **06.04.2011**
(21) Numéro de dépôt: 10181117.2
(22) Date de dépôt: 28.09.2010
(51) Int. Cl.: H01L 27/146

(54) **Capteur d'image face arrière**

(30) Priorité: 30.09.2009 FR 0956775
(71) Demandeur: STMicroelectronics SA, 92120 Montrouge (FR)
(72) Inventeur: Vaillant, Jérôme, 38000, Grenoble (FR)
(74) Mandataire: de Beaumont, Michel

(57) **Abrégé**

L'invention concerne un capteur d'images couleur à éclairement par la face arrière comportant, du côté de la couche mince semiconductrice (1) opposé à la face éclairée, des irrégularités d'épaisseur périodiques (41) formant un réseau optique dont les caractéristiques (Λ, d) sont propres à réfléchir une longueur d'onde donnée choisie parmi les longueurs d'onde d'éclairement.

## Description

### Domaine de l'invention

La présente invention concerne de façon générale la réalisation sous forme monolithique d'imageurs. Plus particulièrement, la présente invention concerne la structure de capteurs d'images de type capteurs à éclairement par la face arrière, couramment appelés capteurs face arrière.

### Exposé de l'art antérieur

Un capteur d'images est constitué d'un réseau de cellules propres à effectuer une transformation photoélectrique. Les cellules sont disposées aux noeuds d'une matrice de lignes et de colonnes. Chaque cellule comprend une photodiode associée à un transistor de transfert et éventuellement d'autres transistors.

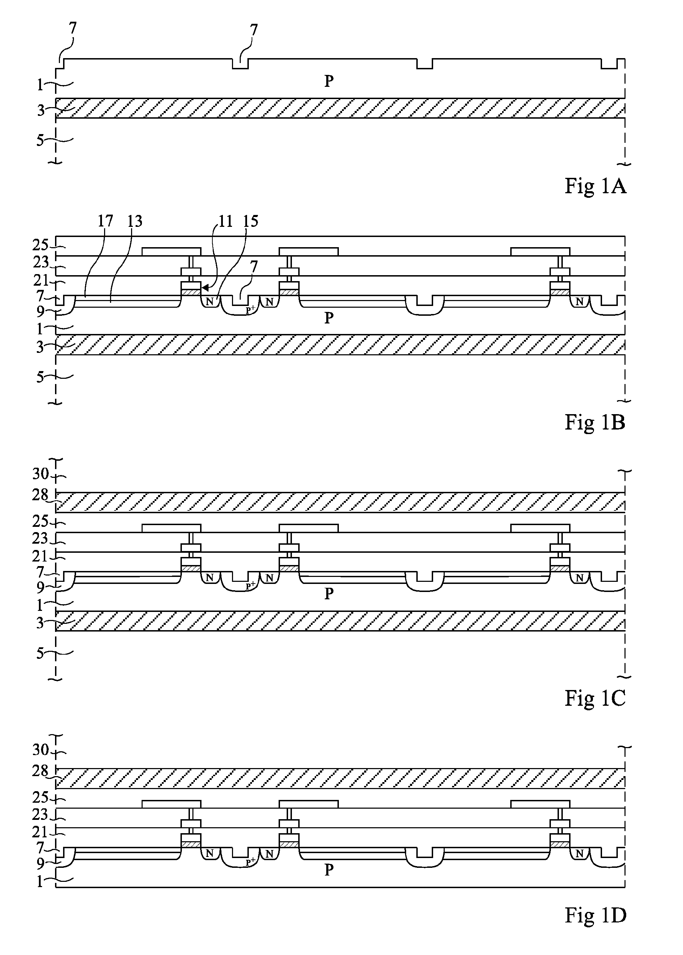

Un exemple de capteur face arrière va être décrit en relation avec les figures 1A à 1E qui sont des vues en coupe partielles et schématiques illustrant des étapes successives de formation d'un tel capteur.

La figure 1A représente une tranche de type silicium sur isolant (SOI) comprenant une couche mince 1 de silicium monocristallin séparée par une couche isolante 3 d'un substrat massif 5. La couche mince 1 est faiblement dopée de type P. Le procédé comporte une étape initiale de creusement de tranchées 7 destinées à délimiter les zones dans lesquelles seront formées les cellules élémentaires comportant notamment une photodiode et son transistor de transfert. A ce stade du procédé, des tranchées d'isolement 7 remplies d'un matériau isolant sont généralement également formées aux limites entre les zones de formation des cellules élémentaires pour assurer un isolement dit STI (Shallow Trench Isolation ou isolement par tranchées peu profondes) entre ces cellules.

Les figures 1A à 1E illustrent seulement quatre tranchées d'isolement 7 délimitant trois zones de formation de cellules individuelles constituées chacune d'une photodiode associée à son transistor de transfert.

Comme l'illustre la figure 1B, les tranchées 7 sont généralement entourées d'une région 9 plus fortement dopée de type P que la couche mince 1. Ensuite, les grilles isolées 11 des transistors MOS sont formées sur la couche mince 1. De part et d'autre des grilles 11 sont formées par implantation-diffusion des régions de drain 13 et de source 15 dopées de type N. Les transistors de transfert sont asymétriques. Dans chaque cellule, la source 15 est plus petite que le drain 13 qui constitue la cathode de la photodiode. Le drain 13 occupe la majeure partie de chaque cellule.

La surface de la région de drain 13 peut être recouverte d'une région d'inversion 17 de faible épaisseur plus fortement dopée de type P que la couche mince 1. La couche mince 1 est recouverte d'une succession de niveaux d'interconnexion permettant d'assurer les connexions nécessaires. Ces niveaux d'interconnexion comprennent des métallisations et des vias (non référencés) formés entre des couches isolantes successives 21, 23, 25. Seules trois couches isolantes sont représentées. Toutefois leur nombre peut être plus élevé, par exemple compris entre quatre et neuf.

Ensuite, comme cela est représenté en figure 1C, on fixe à la structure, sur une couche isolante 28 revêtant le dernier niveau d'interconnexion, une plaquette d'un matériau semiconducteur ou poignée 30.

Comme l'illustre la figure 1D, le substrat 5 est alors retiré, généralement par polissage mécano-chimique, de façon à exposer la face arrière de la couche mince 1.

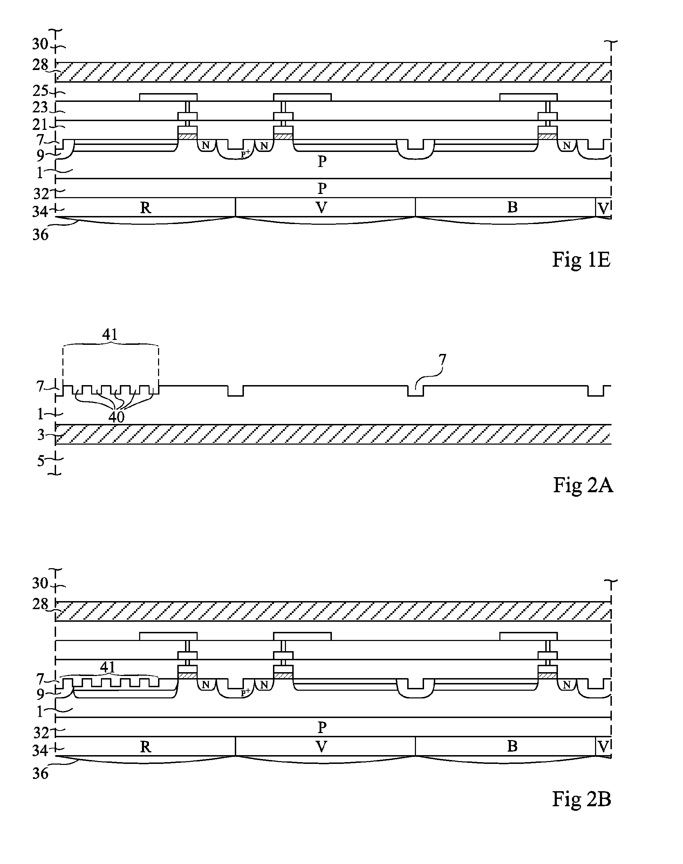

Comme l'illustre la figure 1E, la face arrière est ensuite recouverte successivement d'une couche 32 fortement dopée de type P, et de filtres colorés 34 et de lentilles 36 associés à chaque cellule.

En fonctionnement, un faisceau lumineux incident du spectre visible est concentré par les lentilles 36 dans les diverses cellules à travers les filtres 34. Les photons d'une plage de longueur d'onde du faisceau incident sélectionnée par le filtre 34 sont convertis par effet photoélectrique en porteurs (électrons) et s'accumulent dans la région de cathode/drain 13, d'où ils sont transférés vers des circuits de lecture et d'analyse non représentés par les transistors de transfert.

Un problème rencontré dans la fabrication de tels capteurs réside dans le choix de l'épaisseur de la couche mince 1 qui constitue la zone de transformation des photons en charges électriques. D'une part, pour éviter des effets d'interférences entre cellules voisines, il faut que cette couche soit aussi fine que possible : typiquement équivalente à la taille du pixel, soit 1 à 2 µm pour un pixel de 1,4 µm de côté. De telles épaisseurs permettent de garantir une efficacité quantique de conversion proche de 100% pour les faibles longueurs d'onde, c'est-à-dire dans le bleu et le vert, mais conduisent à une perte d'efficacité de 30 à 60 % pour des longueurs d'onde dans le domaine du rouge. D'autre part, cette couche doit être suffisamment épaisse pour que la majorité des photons incidents soient convertis : plus de 5 µm pour garantir l'absorption de 90% des photons correspondant à la partie rouge du spectre visible.

Ces contraintes conduisent à utiliser des couches minces 1 d'une épaisseur de 2 à 3 µm.

Pour pallier à cette perte, on a proposé de placer une couche métallique réfléchissante du côté des grilles des transistors de sorte que les photons non convertis passent une deuxième fois dans la couche de conversion photoélectrique.

Toutefois, l'insertion d'un élément métallique supplémentaire dans la structure présente l'inconvénient d'impliquer des couplages capacitifs parasites.

En outre, en microélectronique, tous les métaux sont normalement traités et déposés de façon à être non réfléchissants. Introduire une couche métallique réfléchissante implique des modifications importantes des conditions de fabrication.

### Résumé

Un objet d'un mode de réalisation de la présente invention est de proposer un capteur face arrière ayant une efficacité quantique améliorée.

Un autre objet d'un mode de réalisation de la présente invention est de proposer un tel capteur sans augmenter l'épaisseur de la couche mince dans laquelle sont formés les composants.

Un autre objet d'un mode de réalisation de la présente invention est de proposer un tel capteur sans modifier la structure du transistor de transfert.

Un autre objet d'un mode de réalisation de la présente invention est de proposer un tel capteur sans imposer l'introduction de nouveaux matériaux dans les procédés de fabrication ni de traitements particuliers supplémentaires de matériaux couramment utilisés.

Ainsi, un mode de réalisation de la présente invention prévoit un capteur d'images couleur à éclairement par la face arrière comportant, du côté de la couche mince semiconductrice opposé à la face éclairée, des irrégularités d'épaisseur périodiques formant un réseau optique dont les caractéristiques sont propres à réfléchir une longueur d'onde donnée du spectre visible choisie parmi les longueurs d'onde d'éclairement.

Selon un mode de réalisation de la présente invention, les irrégularités correspondent à des évidements dans le silicium remplis d'oxyde de silicium.

Selon un mode de réalisation de la présente invention, les irrégularités sont des plots séparés par des tranchées.

Selon un mode de réalisation de la présente invention, il est prévu uniquement des réseaux optiques pour les cellules du capteur associées à des filtres laissant passer le rouge.

### Brève description des dessins

Ces objets, caractéristiques et avantages, ainsi que d'autres seront exposés en détail dans la description suivante de modes de réalisation particuliers faite à titre non-limitatif en relation avec les figures jointes parmi lesquelles :
les figures 1A à 1E illustrent partiellement et schématiquement en vue en coupe des étapes successives de fabrication d'un capteur d'images ;
la figure 2A est une vue en coupe partielle et schématique d'un capteur d'images selon un mode de réalisation de la présente invention à un stade intermédiaire de fabrication ; et
la figure 2B est une vue en coupe partielle et schématique d'un capteur d'images selon un mode de réalisation de la présente invention à un stade final de fabrication.

### Description détaillée

Par souci de clarté, de mêmes éléments ont été désignés par de mêmes références aux différentes figures et, de plus, comme cela est habituel dans la représentation des circuits intégrés, les diverses figures ne sont pas tracées à l'échelle.

La figure 2A représente un substrat monocristallin, du même type que celui de la figure 1A constitué par exemple d'une couche semiconductrice mince 1 d'une structure de type silicium sur isolant séparée par un isolant mince 3, couramment de l'oxyde de silicium, d'un substrat massif 5. Le procédé comprend une étape initiale de délimitation de portions de la couche mince 1 dans lesquelles doivent être formées des cellules élémentaires du capteur. Cette délimitation est assurée par le creusement de tranchées 7. A ce stade, des évidements 40 sont simultanément creusés dans la couche mince 1 de façon à former à la surface de la couche mince 1 une zone d'irrégularités 41. Selon un mode de réalisation, les évidements 40 sont creusés de façon que les irrégularités 41 sont des plots carrés plutôt que des tranchées rectilignes. L'emplacement de la zone 41 et la répartition des irrégularités seront décrits ultérieurement.

Le procédé se poursuit par des étapes similaires à celles décrites en relation avec les figures 1B à 1E, incluant notamment le remplissage des tranchées 7 et 40, la formation de grilles isolées 11, la formation de différentes régions implantées 9, 13, 15 et 17, la réalisation des niveaux d'interconnexion 21, 23 et 25, la mise en place d'une poignée sur les niveaux de métallisation, un amincissement propre à exposer la face arrière de la couche mince 1 par retrait du substrat 5 et d'au moins une partie de la couche isolante 3, et la formation de filtres 34 et de lentilles 36. Le résultat de ces différentes étapes est illustré en figure 2B.

Comme cela est représenté en figure 2B, la zone d'irrégularités 41 est disposée façon à se trouver dans une cellule élémentaire dont le filtre 34 est rouge, en-dehors de la zone de formation du transistor de transfert, au niveau de la partie de la surface de la couche mince 1 située à l'aplomb de la région de cathode/drain 13.

Les irrégularités 41 forment un motif périodique constitué de plots entourés de tranchées. Ces plots pourront être à base carré, mais seront de préférence à base circulaire ou hexagonale pour ne pas privilégier un type de polarisation de la lumière. La période Λ du motif, la hauteur d des plots ainsi que le rapport entre la largeur des plots et la largeur de l'intervalle les séparant sont choisis de façon que l'ensemble des irrégularités périodiques forme un réseau optique à deux dimensions propre à réfléchir des longueurs d'onde correspondant à la couleur rouge du spectre visible.

Ainsi, un faisceau incident d'éclairement du spectre visible traversant un filtre 34 rouge est réfléchi par la zone d'irrégularités 41 et retraverse la région de cathode 13. Cela revient à doubler virtuellement l'épaisseur de la région de cathode 13. La probabilité d'apparition d'un effet photoélectrique est donc doublée.

Un avantage d'une telle structure est que l'effet de réflexion est meilleur avec un réseau à deux dimensions qu'avec une couche réfléchissante.

Un autre avantage est que ce résultat est obtenu sans introduire de matériau nouveau par rapport aux structures connues. Le procédé de fabrication n'est donc pas compliqué. En particulier, les irrégularités 41 peuvent être formées sans ajouter d'étapes supplémentaires en creusant la couche mince 1 pour former les plots en même temps que sont creusés dans d'autres parties de la couche mince 1 des zones d'isolement de type tranchées STI. Bien que l'on ait représenté les plots et les zones d'isolement avec des largeurs différentes, ces largeurs pourront être identiques.

Selon un mode de réalisation, la couche mince 41 est une couche de silicium monocristallin d'une épaisseur de 3 à 5 µm et la couche isolante remplissant l'intervalle entre les plots est une couche d'oxyde de silicium. On notera que les indices optiques du silicium et de l'oxyde de silicium sont nettement différenciés, respectivement voisins de 4 et de 1,45, ce qui est favorable à l'obtention d'un réseau optique efficace.

Pour une photodiode associée à un filtre rouge, les irrégularités 51 auront par exemple les caractéristiques suivantes :
- période A : de l'ordre de 350 à 400 nm ;
- hauteur d des plots : de l'ordre de 50 à 300 nm ;
- rapport entre la largeur des plots et la distance entre plots voisin de 1.

Des modes de réalisation particuliers de la présente invention ont été décrits. Diverses variantes et modifications apparaîtront à l'homme de l'art. En particulier, on a décrit la présente invention appliquée à un type particulier de capteur face arrière à base de photodiodes. Ce capteur est susceptible de diverses variantes. De plus, tous les capteurs face arrière sont confrontés au même problème et la solution proposée ici s'applique également à d'autres capteurs face arrière. Par exemple, la présente invention s'applique également à des capteurs à base de phototransistors ou de photogrilles.

Par ailleurs, on notera que les irrégularités 41 n'ont été décrites qu'en relation avec une cellule élémentaire associée à un filtre rouge. Ceci constitue un mode de réalisation préféré de la présente invention. En effet, les filtres couramment utilisés sont toujours imparfaits, et en évitant de réfléchir le rouge dans les cellules vertes et bleues, on limite la conversion de la lumière rouge parasite dans ces cellules. On pourra toutefois prévoir pour chaque couleur un réseau de plots spécifique de pas adapté pour réfléchir la couleur souhaitée du spectre visible choisie parmi les longueurs d'onde d'éclairement.

De façon générale, bien que la présente invention a été décrite dans le cadre d'une filière de silicium elle s'applique à toute filière de fabrication de circuits intégrés.

## Revendications

1. Capteur d'images couleur à éclairement par la face arrière comportant, du côté de la couche mince semiconductrice (1) opposé à la face éclairée, des irrégularités d'épaisseur périodiques (41) formant un réseau optique dont les caractéristiques (Λ, d) sont propres à réfléchir une longueur d'onde donnée choisie parmi les longueurs d'onde d'éclairement.

2. Capteur selon la revendication 1, dans lequel les irrégularités correspondent à des évidements dans le silicium remplis d'oxyde de silicium.

3. Capteur selon la revendication 1 ou 2, dans lequel les irrégularités (41) sont des plots (40) séparés par des tranchées.

4. Capteur selon l'une quelconque des revendications 1 à 3, dans lequel il est prévu uniquement des réseaux optiques pour les cellules du capteur associées à des filtres (34) laissant passer le rouge.
